# EUROPEAN PATENT APPLICATION

(11) **EP 4 456 113 A1**
(43) Date of publication of application: **30.10.2024**
(21) Application number: 24171860.0
(22) Date of filing: 23.04.2024
(51) Int. Cl.: H01J 49/02, H01J 49/10

(54) **IMPEDANCE MATCHING CIRCUIT USING INSULATED AIR CORE TRANSFORMER AND MASS SPECTROMETER INCLUDING THE SAME**

(30) Priority: 25.04.2023 KR 20230054158; 19.04.2024 KR 20240052522
(71) Applicant: Young In Ace Co., Ltd., Anyang-si, Gyeonggi-do 14042 (KR)
(72) Inventor: OSIPOV, Vadim, Gyeonggi-do (KR); KIM, Eun Do, Gyeonggi-do (KR); KANG, Sung Won, Gyeonggi-do (KR)
(74) Representative: Kuhnen & Wacker Patent- und Rechtsanwaltsbüro PartG mbB

(57) **Abstract**

Disclosed is a mass spectrometer includes a sample introduction part, an ionization part connected to the sample introduction part, and including a plasma coil that ionizes a sample introduced from the sample introduction part, an RF power supply part electrically connected to the ionization part, and that supplies RF power to the ionization part, an ion lens part including an extraction lens being adjacent to the ionization part and a guide lens that guides an ion beam extracted from the extraction lens, and a detection part that detects the ion beam. The RF power supply part include an impedance matching circuit that controls a voltage due to an inductance component of the plasma coil.

## Description

### CROSS-REFERENCE TO RELATED APPLICATIONS

This application claims priority under 35 U.S.C. § 119 to Korean Patent Application No. 10-2023-0054158 filed on April 25, 2023, and Korean Patent Application No. 10-2024-0052522 filed on April 19, 2024 in the Korean Intellectual Property Office, the disclosures of which are incorporated by reference herein in their entireties.

### BACKGROUND

Embodiments of the present disclosure described herein relate to a mass spectrometer, and more particularly, relate to an impedance matching circuit using an insulated air core transformer, and a mass spectrometer including the same.

As air and water pollution, including fine dust, accelerates, methods for measuring and analyzing it are required. A mass spectrometer may be used for such measurement and analysis.

The mass spectrometer is an instrument that identifies or analyzes chemical agents, through mass spectrometry. The mass spectrometer may analyze the composition of a sample by measuring the mass of the substance in terms of mass-to-charge ratio. The samples may be ionized in a mass spectrometer by using a variety of methods. The ionized sample may accelerate while passing through an electric and/or magnetic field. That is, the paths of a part or all of the ionized sample may be bent by an electric field and/or a magnetic field. The detector may detect the ionized samples.

Meanwhile, in a mass spectrometer using inductively coupled plasma (ICP), an analysis performance of the mass spectrometer may be decreased due to an influence of the electric field that exists outside the plasma coil. Accordingly, a method for controlling the electric field that exists outside the plasma coil is required.

### SUMMARY

Embodiments of the present disclosure provide an impedance matching circuit using an insulated air core transformer, and a mass spectrometer including the same to increase a measurement accuracy.

According to an aspect of the present disclosure, a mass spectrometer includes a sample introduction part, an ionization part connected to the sample introduction part, and including a plasma coil that ionizes a sample introduced from the sample introduction part, an RF power supply part electrically connected to the ionization part, and that supplies RF power to the ionization part, an ion lens part including an extraction lens being adjacent to the ionization part and a guide lens that guides an ion beam extracted from the extraction lens, and a detection part that detects the ion beam, and the RF power supply part include an impedance matching circuit that controls a voltage due to an inductance component of the plasma coil.

According to an embodiment of the present disclosure, the impedance matching circuit may include first and second capacitors connected in series to each other through a node, the node may be grounded, and the voltage may be decreased by setting values of the first and second capacitors.

According to an embodiment of the present disclosure, when, among the first and second capacitors, the first capacitor is short-circuited, an output terminal of the impedance matching circuit, which is connected to the first capacitor, may be grounded, and a sum of voltages of the first and second capacitors before the first capacitor is short-circuited may be is applied to an output terminal of the impedance matching circuit, which is connected to the second capacitor.

According to an embodiment of the present disclosure, the RF power supply part may include an inductively coupled coil inductively coupled to the plasma coil, and the values of the first and second capacitors may be set so that RF potential ratios of opposite ends of the inductively coupled coil are adjusted.

According to an embodiment of the present disclosure, the RF potential ratios may be inversely proportional to ratios of the values of the first and second capacitors, respectively.

According to an embodiment of the present disclosure, the impedance matching circuit may include first and second variable capacitors, and the impedance matching circuit may match an impedance of a load of the plasma coil and an output impedance of the RF power supply part by varying values of the first and second variable capacitors.

According to an embodiment of the present disclosure, the impedance matching circuit may include an insulated air core transformer including an input coil and an output coil, the first variable capacitor may be connected in series to the input coil, and the second variable capacitor may be connected in parallel to the output coil.

According to an embodiment of the present disclosure, an imaginary part of the impedance of the load may be adjusted by varying the value of the first variable capacitor.

According to an embodiment of the present disclosure, a real part of the impedance of the load may be adjusted by varying the value of the second variable capacitor.

According to an aspect of the present disclosure, an electronic circuit for supplying RF power to an inductively coupled plasma coil includes an RF power source that outputs an RF signal, an impedance matching circuit that process and output the RF signal, and control a voltage due to an inductance component of the plasma coil, and an inductively coupled coil configured to supply the RF power based on a signal output from the impedance matching circuit, to the plasma coil, by using inductive coupling, and the impedance matching circuit controls the voltage by setting values of first and second capacitors.

According to an embodiment of the present disclosure, the first and second capacitors may be connected in series to each other through a node, and the node may be grounded.

According to an embodiment of the present disclosure, when, among the first and second capacitors, the first capacitor is short-circuited, an output terminal of the impedance matching circuit, which is connected to the first capacitor, may be grounded, and a sum of voltages of the first and second capacitors before the first capacitor is short-circuited may be applied to an output terminal of the impedance matching circuit, which is connected to the second capacitor.

According to an embodiment of the present disclosure, the values of the first and second capacitors may be set so that RF potential ratios of opposite ends of the inductively coupled coil are adjusted.

According to an embodiment of the present disclosure, the RF potential ratios may be inversely proportional to ratios of the values of the first and second capacitors, respectively.

According to an embodiment of the present disclosure, the impedance matching circuit may include first and second variable capacitors, and the impedance matching circuit may match an impedance of a load of the plasma coil and an output impedance of the electronic circuit by varying values of the first and second variable capacitors.

### BRIEF DESCRIPTION OF THE FIGURES

The above and other objects and features of the present disclosure will become apparent by describing in detail embodiments thereof with reference to the accompanying drawings.
FIG. 1 illustrates an example of a mass spectrometer according to an embodiment of the present disclosure;
FIG. 2 illustrates an example of an RF power supply part according to an embodiment of the present disclosure;
FIG. 3 is a circuit diagram illustrating a detailed example of an RF power supply part and a plasma coil according to an embodiment of the present disclosure;
FIGS. 4A and 4B illustrate flow of an ionized sample in an interior of an ionization part; and
FIG. 5 illustrates an example of impedance matching according to an embodiment of the present disclosure.

### DETAILED DESCRIPTION

Hereinafter, embodiments of the present disclosure will be described clearly and in detail so that an ordinary person in the art of the present disclosure may easily perform the present disclosure.

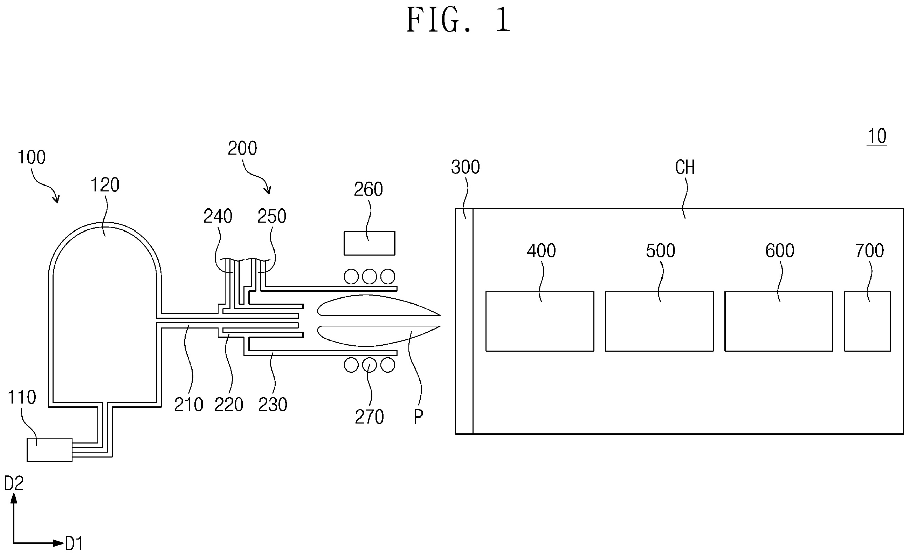

FIG. 1 is a conceptual view illustrating a mass spectrometer according to embodiments of the present disclosure.

Referring to FIG. 1, a mass spectrometer 10 according to the present disclosure may include a sample introduction part 100, an ionization part 200, an interface part 300, an ion lens part 400, a reaction part 500, a mass separating part 600, and a detection part 700. It is illustrated and described that the mass spectrometer 10 according to the present disclosure is a mass spectrometer 10 that uses inductively coupled plasma (ICP), but this is only an example and the present disclosure is not limited thereto, and the mass spectrometer 10 according to the present disclosure may be a mass spectrometer 10 of various types including the ion lens part 400 that will be illustrated and described below.

The sample introduction part 100 may include a nebulizer 110 and a spray chamber 120. The nebulizer 110 may change a sample in a liquid state into an aerosol state, and may inject it into the spray chamber 120. The spray chamber 120 may be connected to the nebulizer 110. The spray chamber 120 may reduce changes of the sample, and maintain a size and an amount of the sample that moves to the ionization part 200, which will be described later, constant. In detail, the spray chamber 120 may remove relatively large aerosols through a temperature control, and may control flow of aerosols so that only relatively small aerosols may move to the ionization part 200. Although not illustrated, a carrier gas may be supplied to the nebulizer 110 and/or the spray chamber 120 through at least one gas supply pipe. The carrier gas may allow the sample to be introduced into the plasma "P".

The ionization part 200 may be connected to the sample introduction part 100. For example, the ionization part 200 may be referred to as a plasma torch. The ionization part 200 may include a first tube 210, a second tube 220, a third tube 230, an RF power supply part 260, and a plasma coil 270.

The first tube 210 may be connected to the spray chamber 120 of the sample introduction part 100, and may be disposed on an innermost side of the ionization part 200. The third tube 230 may be disposed on an outermost side of the ionization part 200, and the second tube 220 may be disposed between the first tube 210 and the third tube 230. The second tube 220 and the third tube 230 may be connected to a first gas supply pipe 240 and a second gas supply pipe 250, respectively. Each of the first to third tubes 210, 220, and 230 may have a hollow pillar shape that extends in a first direction D1. The first to third tubes 210, 220, and 230 may have concentric circular shapes, of which center axes coincide with each other in terms of cross-sectional areas cut in a plane that is perpendicular to the first direction D1. For example, the first to third tubes 210, 220, and 230 may be formed of quartz, alumina, platinum, or sapphire.

The sample and the carrier gas may move through the first tube 210, an auxiliary gas may move through the first gas supply pipe 240 and the second tube 220, and a cooling gas may move through the second gas supply pipe 250 and the third tube 230. The auxiliary gas may prevent or minimize damage to ends of the first and second tubes 210 and 220 due to contact with the plasma "P". The cooling gas may prevent or minimize damage to an inner wall of the third tube 230 due to contact with the plasma "P". For example, the carrier gas, the auxiliary gas, and the cooling gas may include argon (Ar).

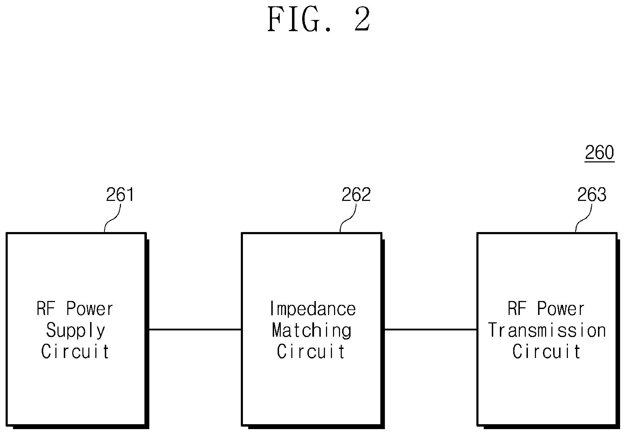

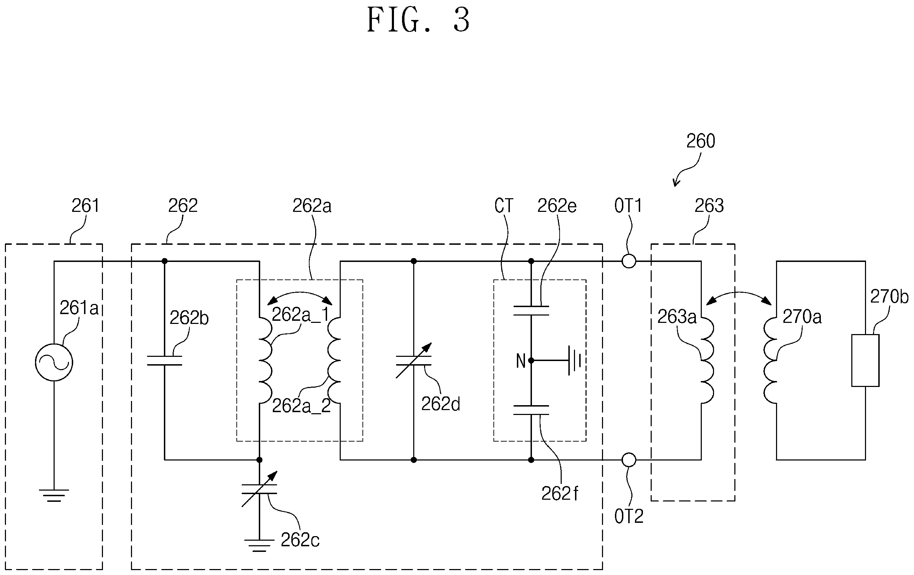

The RF power supply part 260 may supply RF power to the plasma coil 270. For example, the RF power supply part 260 may be configured to deliver maximum power to the plasma coil 270. A detailed description of the RF power supply part 260 will be described later in FIGS. 2 and 3.

For example, the plasma coil 270 may have a spiral shape that surrounds an outside of the third tube 230 at least twice. The plasma coil 270 may generate a strong electromagnetic field that changes over time in an interior of the ionization part 200. For example, the plasma coil 270 may generate a strong electromagnetic field that changes over time in the interior of the ionization part 200 based on the RF power that is supplied from the RF power supply part 260. The electromagnetic field generated by the plasma coil 270 may generate plasma "P" by discharging internal gas. The high temperature plasma "P" may ionize the sample in the aerosol state, which is introduced from the sample introduction part 100.

The interface part 300 may extract the ionized sample from the plasma "P" generated in the ionization part 200, in the form of an ion beam. The interface part 300 may be adjacent to the ionization part 200 in the first direction D1. The interface part 300 may be connected to a chamber CH. The interface part 300 may be provided between the ionization part 200 and the chamber CH. Although not illustrated, the interface part 300 may include a sampler cone and a skimmer cone that extract the ion beam. For example, the sampler cone and the skimmer cone may have a cone shape, of which a width in a second direction D2 increases as it goes in the first direction D1.

The ion lens part 400, the reaction part 500, the mass separating part 600, and the detection part 700 may be provided in an interior of the chamber CH. The interior of the chamber CH may be maintained in a vacuum state. At least one of the ion lens part 400, the reaction part 500, the mass separating part 600, and the detection part 700 may be provided, for example, in sub-chambers in an interior of the chamber CH, and the sub-chambers may be maintained in a higher vacuum state than that of the interior of the chamber CH. The ion lens part 400, the reaction part 500, the mass separating part 600, and the detection part 700 may be disposed, for example, along the first direction D1, but the present disclosure is limited thereto.

The ion lens part 400 may be provided between the interface part 300 and the reaction part 500. The ion lens part 400 may include at least one lens, and may block photons, neutral particles, and the like through one or more lenses, and may control paths of ions that are to be analyzed. For example, the ion lens part 400 may include an extraction lens that extracts an ion beam, and a guide lens that is configured to guide the ion beam extracted by the extraction lens.

The reaction part 500 may be provided between the ion lens part 400 and the mass separating part 600. The reaction part 500 may be referred to as a collision/reaction cell Although not illustrated, the collision/reaction gas may be supplied to the reaction part 500 through at least one gas supply pipe. Collision/reaction gas may collide with various ions in an interior of the reaction part 500, and may convert interfering ions (e.g., ⁴⁰Ar, ⁴⁰Ar¹⁶O, and ³⁸ArH) into non-interfering species or convert ions that are to be analyzed to ions of different masses.

The mass separating part 600 may be provided between the reaction part 500 and the detection part 700. For example, the mass separating part 600 may use a quadrupole scheme, a double focusing magnetic sector scheme, or a time-of-flight scheme, and may separate ions depending on to a mass-to-charge ratio (m/z).

The detection part 700 may be adjacent to a distal end of the mass separating part 600, and may detect a mass spectrum of ions that are to be analyzed, which are separated by the mass separating part 600. For example, the detection part 700 may use a channel electron multiplier, a Faraday cup, or a discrete dynode electron multiplier.

FIG. 2 illustrates an example of the RF power supply part according to an embodiment of the present disclosure. Referring to FIGS. 1 and 2, the RF power supply part 260 may include an RF power supply circuit 261, an impedance matching circuit 262, and an RF power transmission circuit 263.

The RF power supply circuit 261 may output a signal (hereinafter referred to as an `RF signal') having an RF frequency to the impedance matching circuit 262. For example, the RF power supply circuit 261 may output a high-frequency signal to the impedance matching circuit 262.

The impedance matching circuit 262 may receive an RF signal from the RF power supply circuit 261, and may process and transmit the received RF signal. For example, the impedance matching circuit 262 may receive a high-frequency signal from the RF power supply circuit 261, amplify the received high-frequency signal, and transmit it to the RF power transmission circuit 263.

The impedance matching circuit 262 may adjust the RF power supplied to the plasma coil 270. For example, the impedance matching circuit 262 may adjust the RF power supplied to the plasma coil 270 by setting the RF potential ratio transmitted to the RF power transmission circuit 263.

The impedance matching circuit 262 may match an impedance of a load of the plasma coil 270 and an output impedance of the RF power supply part 260. For example, the impedance matching circuit 262 may match the impedance of the load of the plasma coil 270 and the output impedance of the impedance matching circuit 262. As a result of the matching, the impedance matching circuit 262 may efficiently supply the RF power to the plasma coil 270, and may prevent reflected power from the plasma coil 270. Then, the reflected power may mean electric power obtained when at least a portion of the RF power supplied to the plasma coil 270 is reflected from the plasma coil 270 and returns to the RF power supply part 260.

The RF power transmission circuit 263 may receive the processed signal from the impedance matching circuit 262. The RF power transmission circuit 263 may supply the RF power to the plasma coil 270 based on the received signal. For example, the RF power transmission circuit 263 may supply the RF power based on the received signal to the plasma coil 270 by using an inductive coupling scheme.

FIG. 3 is a circuit diagram illustrating a detailed example of the RF power supply part and the plasma coil according to an embodiment of the present disclosure. Referring to FIGS. 1 to 3, the RF power supply part 260 and the plasma coil 270a may be inductively coupled to each other.

The RF power supply circuit 261 may include an RF power source 261a. The RF power source 261a may output an RF signal to the impedance matching circuit 262. For example, the RF power source 261a may output a high-frequency signal to the impedance matching circuit 262. A first terminal of the RF power source 261a may be connected to the impedance matching circuit 262, and a second terminal may be grounded.

The impedance matching circuit 262 may include an insulated air core transformer 262a, an input fixed capacitor OT1, an input variable capacitor OT2, an output variable capacitor 262d, and output fixed capacitors 262e and 262f.

In an embodiment, the impedance matching circuit 262 may further include a metal box that surrounds the impedance matching circuit 262. The metal box may be grounded. The metal box may be configured to be electrically insulated from the impedance matching circuit 262.

The insulated air core transformer 262a may include an input coil 262a_1 and an output coil 262a_2. The insulated air core transformer 262a may process and output the RF signal received from the RF power source 261a. For example, the insulated air core transformer 262a may amplify and output the signal received from the RF power source 261a.

Meanwhile, the impedance matching circuit 262 may be divided or insulated based on the input coil 262a_1 and output coil 262a_2 of the insulated air core transformer 262a. For example, the impedance matching circuit 262 may be divided into a primary circuit including the input coil 262a_1 and a secondary circuit including the output coil 262a_2, and the primary circuit and the secondary circuit may be insulated from each other.

In an embodiment, the secondary circuit may constitute a resonance tank. For example, the output coil 262a_2, the output variable capacitor 262d, and the output fixed capacitors 262e and 262f may constitute a resonance tank. When the secondary circuit forms a resonance tank, the secondary circuit may filter frequencies to stably transmit the RF power. Furthermore, the secondary circuit may stably charge and release energy from the RF power to supply the RF power at a constant rate.

In an embodiment, an outside of the insulated air core transformer 262a may be coated with an insulating material. The insulating material may be an electrically non-conductive material.

In an embodiment, outsides of the input coil 262a_1 and the output coil 262a_2 of the insulated air core transformer 262a may be coated with an insulating material.

The input fixed capacitor OT1 may be connected in parallel to the input coil 262a_1 to compensate for a leakage inductance due to the input coil 262a_1. For example, first terminals of the input fixed capacitor OT1 and the input coil 262a_1 may be connected to the RF power source 261a. Second terminals of the input fixed capacitor OT1 and the input coil 262a_1 may be connected to the first terminal of the input variable capacitor OT2. The second terminal of the input variable capacitor OT2 may be grounded.

The output variable capacitor 262d may be connected in parallel to the output coil 262a_2. For example, the first terminal of the output variable capacitor 262d may be connected to the first terminal of the output coil 262a_2, and the second terminal of the output variable capacitor 262d may be connected to the second terminal of the output coil 262a_2.

The impedance matching circuit 262 may change the values of the input variable capacitor OT2 and the output variable capacitor 262d to match an impedance of a load 270b (hereinafter referred to as `a load 270b') of the plasma coil 270a and an output impedance of the RF power supply part 260. For example, the impedance matching circuit 262 may change the value of the input variable capacitor OT2 so that an imaginary part of the impedance of the load 270b corresponds to an imaginary part of the output impedance of the RF power supply part 260. The impedance matching circuit 262 may change the value of the output variable capacitor 262d so that the real part of the impedance of the load 270b corresponds to the real part of the output impedance of the RF power supply part 260.

The output fixed capacitors 262e and 262f may be connected in series to each other. The output fixed capacitors 262e and 262f connected in series to each may be connected in parallel to the output coil 262a_2 and the output variable capacitor 262d, respectively. For example, the first terminal of an output fixed capacitor 262e, the first terminal of the output coil 262a_2, and the first terminal of the output variable capacitor 262d may be connected to each other. The second terminal of an output fixed capacitor 262f, the second terminal of the output coil 262a_2, and the second terminal of the output variable capacitor 262d may be connected to each other.

The second terminal of the output fixed capacitor 262e and the first terminal of the output fixed capacitor 262f may be connected to each other at a node "N". The node "N" may be grounded. Hereinafter, this structure is referred to as a center tab (CT) structure.

The impedance matching circuit 262 may adjust the RF potential ratios of the output terminals OT1 and OT2 by using the center tab (CT) structure. The RF potential ratios of the output terminals OT1 and OT2 may be inversely proportional to the ratios of the values of the output fixed capacitors 262e and 262f. The impedance matching circuit 262 may adjust the RF potential ratios of the output terminals OT1 and OT2 by setting (or tuning) the values of the output fixed capacitors 262e and 262f.

For example, when, among the output fixed capacitors 262e and 262f, the output fixed capacitor 262e is short-circuited, the output terminal OT1 connected to the output fixed capacitor 262e may be grounded due to the center tab (CT) structure, a maximum voltage (i.e., the sum of the voltages of the output fixed capacitors 262e and 262f before the output fixed capacitor 262e is short-circuited) may be applied to the output terminal OT2.

For example, when, among the output fixed capacitors 262e and 262f, the output fixed capacitor 262f is short-circuited, the output terminal OT2 connected to the output fixed capacitor 262f may be grounded due to the center tab (CT) structure, and the maximum voltage (i.e., the sum of the voltages of the output fixed capacitors 262e and 262f before the output fixed capacitor 262f is short-circuited) may be applied to the output terminal OT1.

As described above, the impedance matching circuit 262 may adjust the RF potential ratios of the output terminals OT1 and OT2 by setting the values of the output fixed capacitors 262e and 262f having a center tab CT.

In an embodiment, the impedance matching circuit 262 may set the values of the output fixed capacitors 262e and 262f by considering a parasitic (C) component of the plasma coil 270a.

In an embodiment, the impedance matching circuit 262 may further include switches that are connected in parallel to the output fixed capacitors 262e and 262f, respectively. For example, a first switch may be connected in parallel to the output fixed capacitor 262e, and a second switch may be connected in parallel to the output fixed capacitor 262f. In this case, when the first switch is turned on, the second switch may be turned off, and when the first switch is turned off, the second switch may be turned on. The output fixed capacitors 262e and 262f may be short-circuited by turning the switches on and off.

The RF power transmission circuit 263 may include output terminals OT1 and OT2 and an inductively coupled coil 263a. The first terminal of the inductively coupled coil 263a may be connected to the output terminal OT1, and the second terminal thereof may be connected to the output terminal OT2. The inductively coupled coil 263a may supply the RF power based on the signal received from the impedance matching circuit 262 to the plasma coil 270a by using an inductive coupling scheme. For example, inductively coupled coil 263a may the RF power based on the RF potentials of the first and second terminals of the inductively coupled coil 263a (i.e., the RF potentials of the output terminals OT1 and OT2) to the plasma coil 270a.

In an embodiment, the output terminals OT1 and OT2 may be electrically isolated from the impedance matching circuit 262.

Meanwhile, when the plasma coil 270a receives RF power from the RF power transmission circuit 263, an electric field may be formed around the plasma coil 270a. The plasma coil 270a may be affected by an electric field that is formed around it.

For example, a voltage (hereinafter referred to as `a plasma coil voltage') that forms an electric field may be generated in the plasma coil 270a due to an 'L' component of the plasma coil 270a. The plasma coil voltage may generate a plasma potential, and the plasma potential may increase the energy of the ionized sample in an interior of the ionization part 200. That is, a speed of the ionized sample introduced into the sampler cone increases, and this may result in loss of ions.

In the present disclosure, the RF potential ratios of the output terminals OT1 and OT2 may be arbitrarily set by using the center tab structure. That is, the impedance matching circuit 262 according to the present disclosure may set the values of the output fixed capacitors 262e and 262f having a center tab (CT) structure to reduce the plasma coil voltage, and may arbitrarily set the RF potential ratios of the output terminals OT1 and OT2. For example, the impedance matching circuit 262 may set the values of the output fixed capacitors 262e and 262f so that the plasma coil voltage is `0'.

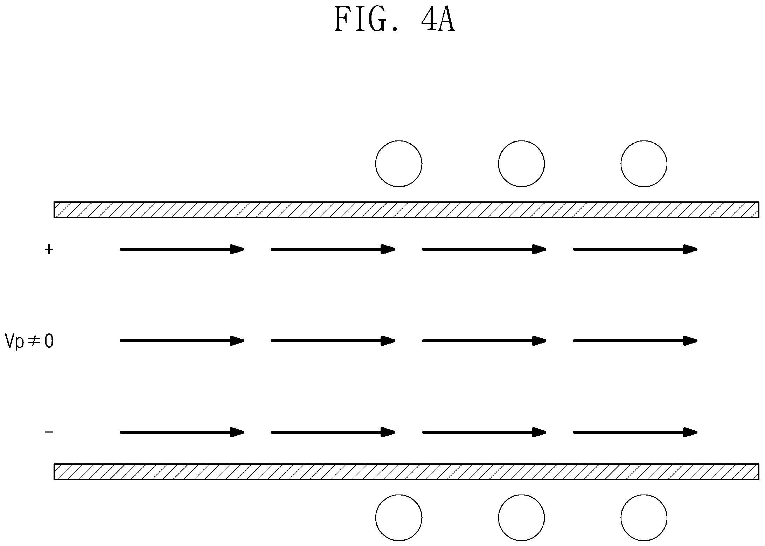

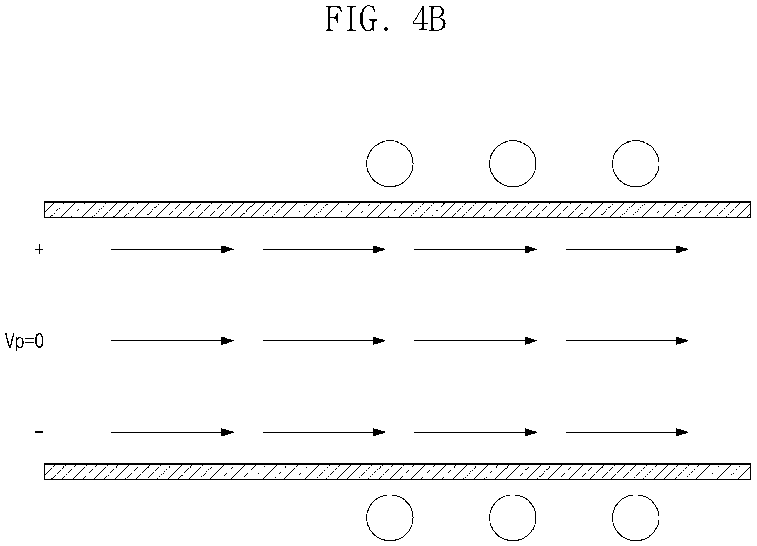

FIGS. 4A and 4B illustrate flow of the ionized sample in the interior of the ionization part. In FIGS. 4A and 4B, it is assumed that the thickness of the arrow represents an intensity of energy of the ionized sample or a magnitude of the speed of the ionized sample. For example, it is assumed that as the arrow becomes thicker, the energy of the ionized sample or the speed of the ionized sample becomes greater.

FIG. 4A illustrates flow of the ionized sample when the center tab (CT) structure is not applied. Referring to FIGS. 1, 3, and 4A, when the RF power is supplied from the RF power transmission circuit 263, a plasma coil voltage Vp due to the 'L' component of the plasma coil 270a may occur in the plasma coil 270a. Accordingly, the energy of the ionized sample may be high. Alternatively, the speed of the ionized sample may be high.

FIG. 4B illustrates flow of ionized sample when the center tab (CT) structure according to the present disclosure is applied. Referring to FIGS. 1, 3, and 4B, when RF power is supplied from the RF power transmission circuit 263, the plasma coil voltage Vp may not be generated in the plasma coil 270a.

Referring to FIGS. 4A and 4B, the energy of the ionized sample when the center tab CT structure is not applied may be higher than the energy of the ionized sample when the center tab CT structure is applied. Alternatively, the speed of the ionized sample when the center tab CT structure is not applied may be higher than the speed of the ionized sample when the center tab CT structure is applied.

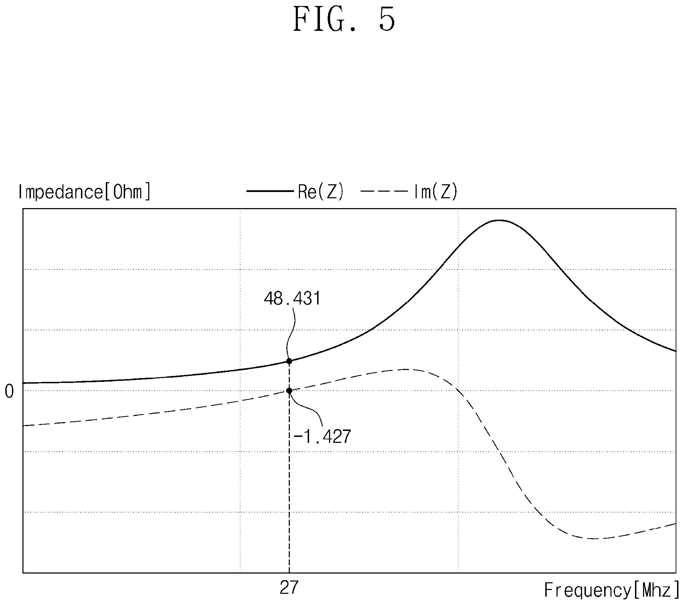

FIG. 5 illustrates an example of impedance matching of the impedance matching circuit according to FIG. 3. In FIG. 5, a transverse axis represents the operating frequency of the RF power source 261a, and a longitudinal axis represents the impedance of the load 270b of the plasma coil 270a. In FIG. 5, it is assumed that an operation frequency of the RF power source 261a is `27' megahertz, and an output impedance of the RF power supply part 260 is '50' ohm. In FIGS. 3 and 5, the impedance matching circuit 262 may change the values of the input variable capacitor OT2 and the output variable capacitor 262d to match the impedance of the load 270b and the output impedance of the RF power supply part 260. As illustrated in FIG. 5, it may be identified that the impedance matching circuit 262 may adjust the real part of the impedance of the load 270b to '48.431' Ohm by varying the output variable capacitor 262d, and may adjust the imaginary part of the impedance of the load 270b `-1.427' Ohm by varying the input variable capacitor OT2.

According to the present disclosure, the impedance matching circuit may prevent the performance of the mass spectrometer from being decreased by the inductance component of the plasma coil. The influence of the electric field that is distributed outside the plasma coil may be minimized. Accordingly, the performance of the mass spectrometer according to the present disclosure may be improved.

In the above-described embodiments, the components according to the technical idea of the present disclosure have been described by using the terms, such as first, second, and third. However, the terms, such as first, second, and third, are used to distinguish components from each other and do not limit the present disclosure. For example, terms, such as first, second, and third do not imply an order or any form of numerical meaning.

The contents described above are detailed examples of implementing the present disclosure. The present disclosure will include not only the embodiments described above, but also embodiments that may be simply changed or easily changed in design. Furthermore, the present disclosure will also include technologies that may be easily modified and implemented in the future by using the above-described embodiments.

## Claims

1. A mass spectrometer comprising:
a sample introduction part;
an ionization part connected to the sample introduction part, and including a plasma coil configured to ionize a sample introduced from the sample introduction part;
an RF power supply part electrically connected to the ionization part, and configured to supply RF power to the ionization part;
an ion lens part including an extraction lens being adjacent to the ionization part and a guide lens configured to guide an ion beam extracted from the extraction lens; and
a detection part configured to detect the ion beam,
wherein the RF power supply part includes:
an impedance matching circuit configured to control a voltage due to an inductance component of the plasma coil.

2. The mass spectrometer of claim 1, wherein the impedance matching circuit includes first and second capacitors connected in series to each other through a node,
wherein the node is grounded, and
wherein the voltage is decreased by setting values of the first and second capacitors.

3. The mass spectrometer of claim 2, wherein when, among the first and second capacitors, the first capacitor is short-circuited, an output terminal of the impedance matching circuit, which is connected to the first capacitor, is grounded, and a sum of voltages of the first and second capacitors before the first capacitor is short-circuited is applied to an output terminal of the impedance matching circuit, which is connected to the second capacitor.

4. The mass spectrometer of claim 3, wherein the RF power supply part includes an inductively coupled coil inductively coupled to the plasma coil, and
the values of the first and second capacitors are set so that RF potential ratios of opposite ends of the inductively coupled coil are adjusted.

5. The mass spectrometer of claim 4, wherein the RF potential ratios are inversely proportional to ratios of the values of the first and second capacitors, respectively.

6. The mass spectrometer of claim 2, wherein the impedance matching circuit includes first and second variable capacitors, and
wherein the impedance matching circuit matches an impedance of a load of the plasma coil and an output impedance of the RF power supply part by varying values of the first and second variable capacitors.

7. The mass spectrometer of claim 6, wherein the impedance matching circuit includes an insulated air core transformer including an input coil and an output coil,
wherein the first variable capacitor is connected in series to the input coil, and
wherein the second variable capacitor is connected in parallel to the output coil.

8. The mass spectrometer of claim 7, wherein an imaginary part of the impedance of the load is adjusted by varying the value of the first variable capacitor.

9. The mass spectrometer of claim 7, wherein a real part of the impedance of the load is adjusted by varying the value of the second variable capacitor.

10. An electronic circuit for supplying RF power to an inductively coupled plasma coil, the electronic circuit comprising:
an RF power source configured to output an RF signal;
an impedance matching circuit configured to process and output the RF signal, and control a voltage due to an inductance component of the plasma coil; and
an inductively coupled coil configured to supply the RF power based on a signal output from the impedance matching circuit, to the plasma coil, by using inductive coupling,
wherein the impedance matching circuit controls the voltage by setting values of first and second capacitors.

11. The electronic circuit of claim 10, wherein the first and second capacitors are connected in series to each other through a node, and
wherein the node is grounded.

12. The electronic circuit of claim 11, wherein when, among the first and second capacitors, the first capacitor is short-circuited, an output terminal of the impedance matching circuit, which is connected to the first capacitor, is grounded, and a sum of voltages of the first and second capacitors before the first capacitor is short-circuited is applied to an output terminal of the impedance matching circuit, which is connected to the second capacitor.

13. The electronic circuit of claim 12, wherein the values of the first and second capacitors are set so that RF potential ratios of opposite ends of the inductively coupled coil are adjusted.

14. The electronic circuit of claim 13, wherein the RF potential ratios are inversely proportional to ratios of the values of the first and second capacitors, respectively.

15. The electronic circuit of claim 14, wherein the impedance matching circuit includes first and second variable capacitors, and
wherein the impedance matching circuit matches an impedance of a load of the plasma coil and an output impedance of the electronic circuit by varying values of the first and second variable capacitors.
